# EUROPEAN PATENT SPECIFICATION

(11) **EP 3 086 366 B1**
(45) Date of publication and mention of the grant of the patent: **23.09.2026**
(21) Application number: 15173530.5
(22) Date of filing: 24.06.2015
(51) Int. Cl.: H10W 40/40

(54) **SEMICONDUCTOR ASSEMBLY**
HALBLEITERANORDNUNG
ENSEMBLE SEMI-CONDUCTEUR

(30) Priority: 23.04.2015 EP 15164821
(43) Date of publication of application: 26.10.2016
(73) Proprietor: ABB Schweiz AG, 5400 Baden (CH)
(72) Inventor: Silvennoinen, Mika, 00380 Helsinki (FI); Manninen, Jorma, 00380 Helsinki (FI); Martinmaa, Juha, 00380 Helsinki (FI)
(74) Representative: Kolster Oy Ab

(56) References cited:
- WO-A1-2004/114404
- DE-A1- 3 247 534
- JP-A- 2000 269 676
- US-A1- 2002 080 583

## Description

### FIELD OF THE INVENTION

The present invention relates to semiconductor assemblies, and particularly to high-power semiconductor assemblies having a cooling structure.

### BACKGROUND OF THE INVENTION

Power electronic modules are widely used components in which multiple of power electronic switches or devices are placed in a single module. The switches of a power electronic module are wired inside the module in specified manner such that power electronic modules can be used in different circuit structures. Such circuit structures are, for example, power stages of different power converters. For that purpose, the power electronic modules may comprise different half-bridge, full bridge or other bridge topologies in which controllable switch components are internally connected with power diodes. The power electronic modules comprise also terminals, such as control terminals and power terminals that allow connecting the modules to other required circuitry and possibly to other modules.

The components inside a power electronic module are typically mounted on a substrate that is thermally connected to the base plate of the module. The base plate is a metallic piece integrated to the bottom of the module and it is intended to be attached to a surface of a cooling member, such as heat sink. The semiconductor switches inside the modules generate heat when the switches are operated. The switched currents can be over hundreds or even thousands of amperes and the voltage blocking ability of the power semiconductors of the module is several thousand volts. These semiconductor switches are further operated at a relatively high frequency of several thousand Hertz.

To keep the temperature of the module at a tolerable range, it is known to attach the module to a heat sink. This is performed by attaching the planar surface of the baseplate to a corresponding planar surface of a heat sink. The heat transfer between the baseplate and the heat sink is enhanced by using a thermal interface material (TIM). Such material or layer is placed between the surfaces of baseplate and heat sink.

DE 32 47 534 A1, and WO 2004/114404 A1 are relevant pieces of prior art disclosing power electronic modules and heat sinks coupled by carbon based TIMs.

One of the most effective heat sinks is a type in which heat pipes are integrated to the surface of the heat sink close to the base plate of the power electronic module. The heat pipes are formed in the surface of the heat sink to spread the generated heat in the mass of the heat sink such that the heat is removed more evenly from the sink to the surroundings. Heat pipes operate in a known manner absorbing heat when liquid inside a pipe evaporates to a gas. The evaporated gas moves inside the pipe towards a cooler place and condenses again into liquid thereby releasing heat. The liquid moves again towards the warmer direction with the aid of capillary and gravity forces.

JP 2000 269676 A, and US 2002/080583 A1 are relevant pieces of prior art disclosing power electronic modules employing heat pipes.

Although heat pipes provide good cooling properties for power semiconductor modules, certain operations are still limited by the excessive heating of the semiconductors. For example some uses of frequency converters that employ power semiconductor modules are limited due to the cooling restraints. In cyclic operation of the power semiconductors the known devices employ overrated components so that the temperature variations due to cyclic loading are kept in tolerable limits.

Another problem is encountered when a high switching frequency of an inverter is required for driving a high speed motor, for example. Although power semiconductors can be switched with required high frequencies, the output power must be brought down so that the temperatures of the semiconductors stay within allowable limits.

In the above examples the high or cycling temperatures are taken account by either limiting the properties of the electronic device or by overrating the components of the electronic device. While the above solutions enable using the electronic devices, the properties of the devices cannot be fully utilized.

### BRIEF DESCRIPTION OF THE INVENTION

An object of the present invention is to provide a power electronic assembly so as to solve the above problem. The object of the invention is achieved by an assembly which is characterized by what is stated in the independent claim. The preferred embodiments of the invention are disclosed in the dependent claims.

The invention is based on the idea of employing a carbon based material layer according to claim 1 between the base plate of the power electronic module and the cooling surface of the cooling arrangement having one or more heat pipes. It has been noticed that the properties of a carbon based material layer are suitable for spreading the heat generated in the power electronic module in a larger surface area such that the heat is transferred to the cooling arrangement more effectively. Further, when the cooling arrangement or heat sink is provided with heat pipes, the heat removal from the power electronic module is dramatically increased. The heat pipes of the cooling arrangement respond very fast to heat load changes and spread the heat effectively and the combined operation of the carbon based material layer and the heat pipes enable to exploit the mass of the cooling arrangement in an effective way. As the mass of the cooling arrangement is evenly heated, the temperature of the cooling arrangement is lower than in the case of uneven distribution of heat. This further means that the cooling arrangement with ability to spread the heat is able to hold the temperature of the semiconductor components lower than in the cases where the heat is not spread.

An advantage of the assembly of the invention is that it enables to increase the cooling of the semiconductor components. As the cooling of the semiconductor components is enhanced, the device in which the semiconductors are used is able to withstand higher switching frequencies without reducing the output power of the device. Similarly, such device can tolerate more cyclic loading as the temperature level and the temperature change is reduced due to the increased cooling performance and faster thermal response time of the heat sink.

Another advantage of using a carbon based material layer is that it can be manufactured to have a low value of hardness. It has been noticed that the base plates of power electronics module undergo changes in the form during the cyclic use. These changes include bending and twisting of the base plate. As the base plates of power electronic modules have a comparatively large surface area, the deformation of the base plate may lead to changes that affect the cooling behaviour as gaps are formed between the cooling arrangement and the base plate.

As the carbon based material is manufactured with a low hardness value it is able to adapt sufficiently to the deformed base plate filling possible gaps that are formed when the base plate has twisted or bent. Further, in addition to the low hardness, the carbon based material layer can be produced with a sufficient thickness which in turn also helps in filling the gaps that are possibly formed during the use of the power electronic module.

### BRIEF DESCRIPTION OF THE DRAWINGS

In the following the invention will be described in greater detail by means of preferred embodiments with reference to the accompanying drawings, in which
Figure 1 illustrates a basic structure of a power electronic assembly;
Figure 2 illustrates the structure of Figure 1 assembled;
Figure 3 shows an example of a top view of placement of semiconductor switch components in a power electronics module;
Figure 4 shows an example of positioning of two heat pipes relative to the semiconductor switch components;
Figure 5 shows a cross section of Figure 4; and
Figure 6 illustrates the spreading of the generated heat.

### DETAILED DESCRIPTION OF THE INVENTION

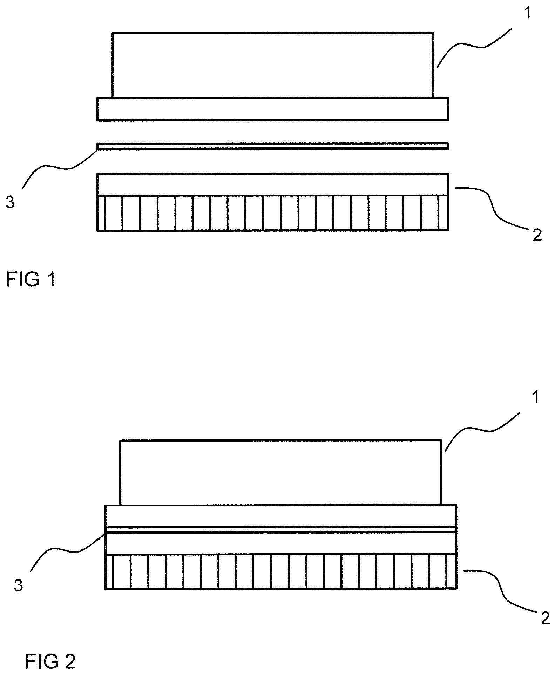

Figures 1 and 2 show a basic structure of a power electronic assembly according to an embodiment. In Figure 1 the main parts of the structure are shown as separated from each other whereas in Figure 2, the assembly is completed. The power electronic assembly comprises a power electronic module 1, cooling arrangement 2 with heat pipes and a carbon based material layer 3 according to claim 1.

The power electronic module is a component enclosing multiple of power electronic switches. Such modules are used in building power electronic devices which large currents are switched and which use high voltages. Typical way of operating such power semiconductor switches is to have the component either fully conducting or blocking such that current is flowing through the component only when the voltage across the component is close to zero. Although the components are controlled in such a manner, that losses are minimized, some losses are incurring both during the switching instants and during conduction. The losses of the switch components cause the module to generate heat which can be detrimental to the components if not removed from the module. The Figures 1 and 2 are presented as examples for better understanding the idea of the invention. It should be noted that the Figures 1 and 2 do not present the components of the assembly in scale. For example, the carbon based material layer is shown as a thick block in the Figures for illustrative purposes.

For removing the heat from the modules, the modules are typically structured internally in such a manner that the heat is conveyed to the base plate of the module and the temperature of the switch components can be kept within allowable limits by removing the heat from the component through the base plate. The base plate is integral part of the module and is typically metallic to enable to transfer heat via the base plate. The physical length of the base plate is in the range of hundreds of millimetres.

For removal of the heat the bottom plate is mechanically connected to a mating surface of a cooling arrangement. The cooling arrangement thus has a surface that can receive the heat from the power electronic module and to further transfer the heat to keep the temperature of the semiconductor chips at allowable limits.

According to the present invention, the cooling arrangement comprises one or more heat pipes. The heat pipes are formed in the cooling surface of the cooling arrangement for spreading the heat in the cooling arrangement and for removing the heat.

At least one of the heat pipes is preferably arranged at the surface of the cooling surface, that is, the surface of the heat pipe forms part of the cooling surface of the cooling arrangement. The at least one heat pipe is thus visible in the surface of the cooling arrangement. As it is preferred to have the cooling surface even, the at least one heat pipe is formed such that the surface of the heat pipe is even with the rest of the surface leaving no gaps that could hinder the thermal connection.

The cooling element may comprise heat pipes which are inside the cooling arrangement for spreading the heat inside the heating mass. The heat sink or similar cooling arrangement may be machined to include drillings or cavities to which heat pipes can be installed in desired manner.

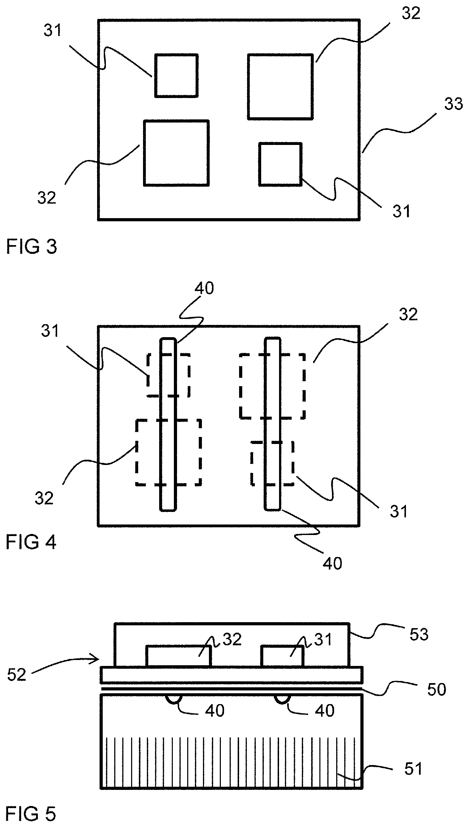

According to an aspect of the invention, heat pipes are arranged substantially below the semiconductor switch components of the power electronic module such that at least two semiconductor components are situated in close proximity of a same heat pipe. Figure 3 shows a simplified example of placement of semiconductor chips in a power electronic module. Figure 3 is an illustration seen from the top of the module showing the baseplate 33 and two IGBT chips 32 and two diode chips 31. The IGBT chips are somewhat larger than the diode chips and have also higher losses than the diode chips.

Figure 4 shows a cooling arrangement with two heat pipes 40. Figure 4 shows also the placement of semiconductor chips 31, 32 of Figure 3 with respect the heat pipes when module and the cooling arrangement 34 are installed to each other. It is seen in the Figure 4 that the heat pipes are aligned such that one IGBT and one diode are in close proximity with each heat pipe.

The close proximity means that the semiconductor chips are placed above heat pipes as shown in Figure 5 which is a cross section of the example of Figure 4 at the point of the semiconductor switches. It is known that diodes usually generate lower amount of heat than the IGBT:s. Therefore the mass of the cooling structure is used efficiently when heat generated by the IGBT is spread also in the areas which are heated by the losses of the diode.

Figure 5 shows the heat pipes 40 below the chips of semiconductor switches 31, 32. The semiconductor switches are in a power semiconductor module 52 and shown inside a casing 53 of the module. Figure 5 shows also cooling arrangement 34 with cooling fins or ribs 51 and the carbon based material layer 50. For illustrative reasons the power semiconductor module 52, the cooling arrangement 34 and the carbon based material layer 50 are separated from each other.

According to the present invention, the power electronic assembly comprises a carbon based material layer according to claim 1, which is arranged between the base plate of the power electronic module and the cooling surface of the cooling arrangement. The carbon based material layer is adapted to spread the heat generated by the semiconductor power electronic switch components in addition to transferring the heat to the cooling arrangement.

The carbon based material is in the form of a separate layer, that is put between the base plate and cooling surface during the installing of the assembly. The carbon based material is in form of a soft layer having a thickness ranging from 75 µm to 250 µm. The carbon based material is natural graphite, pyrolytic graphite or synthetic graphite.

The softness and thickness of the material allows it to adapt and fill sufficiently gaps between surfaces of the base plate of the power electronic module and the cooling surface of the cooling arrangement during the attachment of the module to the cooling surface.

Power electronic module operation and power cycling during the operation causes base plate to bend and/or twist. This means that distance between the power electric module base plate and the cooling surface varies thus causing varying thermal resistance between the parts. However, the material described above has specific properties that compensate the downside effects of the deforming base plate to power electronic module cooling. These material properties include a sufficient initial thickness that's case dependent and very low hardness (less than 10 at Shore 00) allow the material to adapt and fill gaps between surfaces of the base plate of the power electronic module and the cooling surface.

Additional benefit of carbon based material's very low hardness is that the power electronic module fixing screws need no retightening after assembly. There will be hardly any remaining tension in the assembly that could release over time and cause loose fastenings.

Further, the carbon based material has a sufficiently high in-plane thermal conductivity (>200 W/mK) and through-thickness thermal conductivity (> 3 W/mK). During operation the combined effect of in-plane and through-thickness conductivities effectively balances the local thermal resistance increase caused by the air gaps that may be formed.

The carbon layer contains small enough (nano) particles that can penetrate and fill surface structures of base plate and cooling surface. Further, carbon materials, especially graphite, have good lubrication properties compared to metals, for example. This property allows the carbon layer to withstand mechanical forces related to deformation of the power electronic module during assembly and operation. The material stays in place and it doesn't tear into pieces.

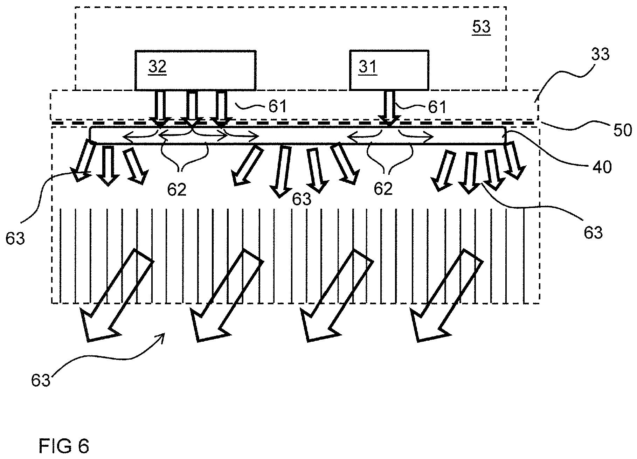

Figure 6 shows the heat transfer from the semiconductor chips 31, 32 to the surrounding air. When the semiconductor chips are heated during the use of the power semiconductor module, the heat is transferred through the base plate to the carbon based material layer 50 which act as a thermal interface between the base plate and the cooling arrangement. As mentioned above, the carbon based material layer has good thermal conductivity both in through thickness and in-plane directions. As the heat is transferred to the cooling arrangement it is also spread across the carbon based material layer which increases the heat transfer from the base plate and helps in cooling the power semiconductors. A heat pipe 40 which is placed in close proximity with the power semiconductors heats up 61 in the area nearest to the power semiconductors and the liquid inside the heat pipe near the heated spots absorbs heat and evaporates and starts flowing 62 towards cooler places inside the pipe. Once the temperature of the gas is lowered, it releases heat 63 to the surrounding mass of the cooling arrangement and changes its phase to liquid again. The mass of the cooling arrangement is heated evenly with the aid of the carbon based material layer and the heat pipe which both spread the heat.

The heat is further removed 64 to the surrounding air from the surface of the cooling arrangement and typically sufficient heat transfer rate is obtained by using fins or ribs and the removal of heat may be increased by using blowers to keep the air moving in the fins or ribs. The heat transfer in Figure 6 is shown with arrows together with the mentioned reference numerals for better understanding the procedure. Although Figure 6 shows that heat is removed from the semiconductor switches using only the heat pipe, it should be appreciated that the carbon based material layer spreads the generated heat and also transfers heat from the base plate to the cooling arrangement.

In the above examples one or more heat pipes are shown to be arranged in certain level in the cooling arrangement, i.e. the distance from the top of the cooling arrangement to the heat pipes is the same. It is clear that when the heat pipes are in the surface of the cooling surface of the cooling arrangement, the heat transfer to the heat pipe is maximal. However, in order to spread the heat in the mass of the cooling arrangement it may be advisable to arrange one or more heat pipes with differing orientation. For example, the heat pipes may be arranged in different levels and orientation. First part of the heat pipes may be arranged in one direction at the surface of the cooling element and second part of the heat pipes may be arranged perpendicular to the first part of the heat pipes such that the second part of the heat pipes are situated completely inside the cooling arrangement. The heat pipes may thus be situated in multiple of levels in the cooling arrangement.

One or more of the heat pipes may also be at an angle deviating from zero with respect to the cooling surface of the cooling arrangement. In such a case one end of the heat pipes may be arranged to be at the surface of the cooling surface while the other end is deeper inside the cooling element.

Further, one end of the heat pipe may be brought out of the cooling structure and it may be arranged in the cooling fins or ribs of the cooling element. In such arrangement the heat is brought outside the mass of the cooling arrangement using the heat pipe. In such a case the heat pipe has a curved shape. Heat pipes may have curved shapes also inside the mass of the cooling arrangement or at the surface of the cooling surface.

The power electronic assembly is typically employed in a power electronic device. The power electronic device of the invention comprises one or more power electronics assemblies of the invention. A power electronic device is, for example, a converter, an inverter, a frequency converter or any other high-power device. Typically a power electronics device is a device that outputs controlled voltage or current to be supplied to a load. The power electronic assembly contains electrical terminals, such as control terminals and output terminals, with which the power electronics assembly can be coupled to other circuit structures and to enable operation of the circuit.

The method of the invention enables to produce the power electronic assembly. In the method, a power electronic module and a cooling arrangement with one or more heat pipes are provided. The power electronic module comprises a base plate and the cooling arrangement comprises a cooling surface. In the method, a carbon based layer is provided between the base plate of the power electronic module and the cooling surface of the cooling arrangement. The power electronic module is further fastened to the cooling arrangement using fastening means. The fastening means are preferably screws or bolts with which components of the assembly are held firmly together. The screws or bolts are tightened to a specified torque which depends on the module and is typically given by the manufacturer of the power electronic module. Typically the power electronic module comprises through holes through which bolts can be assembled. The cooling arrangement has corresponding threaded holes to which the bolts can attach such that the mating surfaces are firmly against each other. The assembly of the invention does not require any modifications to the base plate, cooling surface or to fastening of the module and the cooling arrangement.

According to an embodiment, the thickness of the carbon based layer varies such that the layer is thinner in the areas near the fixing points of the module and the cooling arrangement than in the locations further away from the fixing points. With such a non-uniform layer, the pressure between the surfaces is higher in the center area of the surfaces. This further means that the ability of the material to fill gaps formed during the use of the power electronic assembly is increased.

Joint effect of the above mentioned properties make carbon an excellent thermal interface material between power electronic module base plate and a cooling surface of a cooling arrangement. This type of material has very good heat transfer properties and it is proven to have superior service life too. As mentioned above, carbon based layer also effectively spreads the heat in planar directions and thereby works together with the heat pipes of the invention to spread the heat evenly to the mass of the cooling arrangement.

It has been found out that carbon based TIM materials offer similar heat conducting properties to metallic foils, thermal greases and phase change TIMs. Decisive advantage of carbon based TIM, especially graphite TIM over other alternatives is its ability to endure shear loads and maintain good enough thermal contact. Shear loads are caused by power cycling and mismatches of coefficients of thermal expansion over the thermal interface.

In the description the semiconductor components of the module are commonly referred to as diodes and IGBT:n. It is however clear that the power electronic module may hold any other high power switch components which require cooling due to the high losses.

In the description relative terms are used for indicating relations of certain components and parts with respect to other components and parts. Examples of such relative terms used include below, top and above. The meaning of such terms is clear with reference to the drawings. For example, when the semiconductor chips are placed above the heat pipes, the composition of the components is such that the heat sink is a lower component having cooling surface orientated horizontally with the heat pipes and the semiconductor components are above the horizontally extending heat pipes. Although the drawings show the orientation of the assembly being such that the cooling structure is the lowermost component, the orientation of the assembly is not limited to that orientation.

## Claims

1. A power electronic assembly comprising a power electronic module (52) having multiple of semiconductor power electronic switch components (31, 32), the power electronic module comprising a base plate (33),
the power electronic assembly comprising further a cooling arrangement (34, 51) for cooling the power electronic module, the cooling arrangement comprising a cooling surface adapted to be attached against the base plate of the power electronic module, wherein
the cooling arrangement comprises further one or more heat pipes (40) formed in the cooling surface for spreading the heat in the cooling arrangement and removing the heat from the cooling arrangement, and
wherein the power electronic assembly comprises further a carbon based material layer (50) arranged between the base pate of the power electronic module and the cooling surface of the cooling arrangement, the carbon based material layer (50) being adapted to spread the heat (61) generated by the semiconductor power electronic switch components and to transfer the heat from the power electronic assembly to the cooling arrangement, wherein the carbon based material layer is a separate layer of natural graphite, pyrolytic graphite or synthetic graphite, wherein the thickness of the carbon based material layer is in the range of 75 µm to 250 µm and wherein the hardness of the carbon based material layer is less than 10 at Shore 00.

2. A power electronic assembly according to claim 1, wherein at least one of the one or more heat pipes is arranged at the surface of the cooling surface of the cooling element.

3. A power electronic assembly according to any one of the previous claims 1 to 2, wherein at least one of the one or more heat pipes is arranged below at least one electronic switch component of the power electronic module when seen from the direction of the power electronic module.

4. A power electronic assembly according to any one of the previous claims 1 to 3, wherein at least one of the one or more heat pipes is arranged below two electronic switch components of the power electronic module when seen from the direction of the power electronic module, and preferably the two electronic switch components have differing power losses.

5. A power electronic assembly according to any one of the previous claims 1 to 4, wherein the assembly comprises at least two heat pipes and wherein the heat pipes are arranged at different levels and/or different orientations in the cooling arrangement.

6. A power electronic assembly according to any one of the previous claims 1 to 5, wherein at least one of the one or more heat pipes are arranged at an angle deviating from zero with respect to the cooling surface of the cooling arrangement.

7. A power electronic assembly according to any one of the previous claims 1 to 6, wherein at least one of the multiple of semiconductor power electronic components of the power electronic module is rated to a current in the range of hundreds of amperes.

8. A power electronic assembly according to any one of the previous claims 1 to 7, wherein the length of the base plate of the power electronic module is in the range of over 100 millimeters.

9. A power electronic device comprising one or more power electronic assemblies according to any one of the previous claims 1 - 8.

10. A power electronic device according to claim 9, wherein the power electronic device is a frequency converter.

11. A method of producing a power electronic assembly comprising the steps of
providing a power electronic module incorporating multiple of semiconductor power electronic switch components, the power electronic module comprising a base plate,
providing a cooling arrangement for cooling the power electronic module, the cooling arrangement comprising a cooling surface adapted to be attached against the base plate of the power electronic module and one or more heat pipes for spreading the heat in the cooling arrangement and removing the heat from the cooling arrangement,
providing a carbon based layer, wherein the carbon based material layer is a separate layer of natural graphite, pyrolytic graphite or synthetic graphite between the base plate of the power electronic module and the cooling surface of the cooling arrangement, the carbon based material layer being adapted to spread the heat generated by the semiconductor power electronic switch components and to transfer the heat from the power electronic assembly to the cooling arrangement, wherein the thickness of the carbon based material layer is in the range of 75 µm to 250 µm and wherein the hardness of the carbon based material layer is less than 10 at Shore 00, and
fastening the power electronic module to the cooling arrangement using fastening means.

## Patentansprüche

1. Leistungselektronikbaugruppe, umfassend ein Leistungselektronikmodul (52) mit mehreren Halbleiter-Leistungselektronikschalterkomponenten (31, 32), wobei das Leistungselektronikmodul eine Basisplatte (33) umfasst,
wobei die Leistungselektronikbaugruppe ferner eine Kühlanordnung (34, 51) zum Kühlen des Leistungselektronikmoduls umfasst, wobei die Kühlanordnung eine Kühlfläche umfasst, die dazu ausgelegt ist, an der Basisplatte des Leistungselektronikmoduls befestigt zu werden, wobei
die Kühlanordnung ferner ein oder mehrere Wärmerohre (40) umfasst, die in der Kühlfläche ausgebildet sind, um die Wärme in der Kühlanordnung zu verteilen und die Wärme aus der Kühlanordnung abzuführen, und
wobei die Leistungselektronikbaugruppe ferner eine kohlenstoffbasierte Materialschicht (50) umfasst, die zwischen der Basisplatte des Leistungselektronikmoduls und der Kühlfläche der Kühlanordnung angeordnet ist, wobei die kohlenstoffbasierte Materialschicht (50) dazu ausgelegt ist, die durch die Halbleiter-Leistungselektronikschalterkomponenten erzeugte Wärme (61) zu verteilen und die Wärme von der Leistungselektronikbaugruppe auf die Kühlanordnung zu übertragen, wobei die kohlenstoffbasierte Materialschicht eine separate Schicht aus natürlichem Graphit, pyrolytischem Graphit oder synthetischem Graphit ist, wobei die Dicke der kohlenstoffbasierten Materialschicht im Bereich von 75 µm bis 250 µm liegt und wobei die Härte der kohlenstoffbasierten Materialschicht bei Shore 00 weniger als 10 beträgt.

2. Elektronische Leistungsbaugruppe nach Anspruch 1, wobei mindestens eines von dem einen oder den mehreren Wärmerohren an der Oberfläche der Kühlfläche des Kühlelements angeordnet ist.

3. Leistungselektronikbaugruppe nach einem der vorhergehenden Ansprüche 1 bis 2, wobei mindestens eines von dem einen oder den mehreren Wärmerohren von der Richtung des Leistungselektronikmoduls aus betrachtet unter mindestens einer elektronischen Schalterkomponente des Leistungselektronikmoduls angeordnet ist.

4. Leistungselektronikbaugruppe nach einem der vorhergehenden Ansprüche 1 bis 3, wobei mindestens eines von dem einen oder den mehreren Wärmerohren von der Richtung des Leistungselektronikmoduls aus betrachtet unter zwei elektronischen Schalterkomponenten des Leistungselektronikmoduls angeordnet ist und vorzugsweise die zwei elektronischen Schalterkomponenten unterschiedliche Leistungsverluste aufweisen.

5. Leistungselektronikbaugruppe nach einem der vorhergehenden Ansprüche 1 bis 4, wobei die Baugruppe mindestens zwei Wärmerohre umfasst und wobei die Wärmerohre auf verschiedenen Ebenen und/oder in unterschiedlichen Ausrichtungen in der Kühlanordnung angeordnet sind.

6. Leistungselektronikbaugruppe nach einem der vorhergehenden Ansprüche 1 bis 5, wobei mindestens eines von dem einen oder den mehreren Wärmerohren in einem Winkel angeordnet ist, der von null in Bezug auf die Kühlfläche der Kühlanordnung abweicht.

7. Leistungselektronikbaugruppe nach einem der vorhergehenden Ansprüche 1 bis 6, wobei mindestens eine der mehreren elektronischen Halbleiter-Leistungselektronikkomponenten des Leistungselektronikmoduls für einen Strom im Bereich von Hunderten von Ampere ausgelegt ist.

8. Leistungselektronikbaugruppe nach einem der vorhergehenden Ansprüche 1 bis 7, wobei die Länge der Basisplatte des Leistungselektronikmoduls im Bereich von über 100 Millimeter liegt.

9. Leistungselektronikvorrichtung, umfassend eine oder mehrere Leistungselektronikbaugruppen nach einem der vorhergehenden Ansprüche 1-8.

10. Leistungselektronikvorrichtung nach Anspruch 9, wobei die Leistungselektronikvorrichtung ein Frequenzwandler ist.

11. Verfahren zur Herstellung einer Leistungselektronikbaugruppe, umfassend die folgenden Schritte:
Bereitstellen eines Leistungselektronikmoduls, das mehrere Halbleiter-Leistungselektronikschalterkomponenten beinhaltet, wobei das Leistungselektronikmodul eine Basisplatte umfasst,
Bereitstellen einer Kühlanordnung zum Kühlen des Leistungselektronikmoduls, wobei die Kühlanordnung eine Kühlfläche, die dazu ausgelegt ist, an der Basisplatte des Leistungselektronikmoduls befestigt zu werden, und
ein oder mehrere Wärmerohre zum Verteilen der Wärme in der Kühlanordnung und Abführen der Wärme aus der Kühlanordnung umfasst,
Bereitstellen einer kohlenstoffbasierten Schicht, wobei die kohlenstoffbasierte Materialschicht eine separate Schicht aus natürlichem Graphit, pyrolytischem Graphit oder synthetischem Graphit zwischen der Basisplatte des Leistungselektronikmoduls und der Kühlfläche der Kühlanordnung ist, wobei die kohlenstoffbasierte Materialschicht dazu ausgelegt ist, die durch die Halbleiter-Leistungselektronikschalterkomponenten erzeugte Wärme zu verteilen und die Wärme von der Leistungselektronikbaugruppe auf die Kühlanordnung zu übertragen, wobei die Dicke der kohlenstoffbasierten Materialschicht im Bereich von 75 µm bis 250 µm liegt und
wobei die Härte der kohlenstoffbasierten Materialschicht bei Shore 00 weniger als 10 beträgt, und
Befestigen des Leistungselektronikmoduls an der Kühlanordnung unter Verwendung von Befestigungsmitteln.

## Revendications

1. Ensemble électronique de puissance comprenant un module électronique de puissance (52) ayant de multiples composants de commutation électroniques de puissance à semi-conducteurs (31, 32), le module électronique de puissance comprenant une plaque de base (33), l'ensemble électronique de puissance comprenant en outre un agencement de refroidissement (34, 51) pour refroidir le module électronique de puissance, l'agencement de refroidissement comprenant une surface de refroidissement conçue pour être fixée contre la plaque de base du module électronique de puissance, dans lequel l'agencement de refroidissement comprend en outre un ou plusieurs caloducs (40) formés dans la surface de refroidissement pour répandre la chaleur dans l'agencement de refroidissement et évacuer la chaleur de l'agencement de refroidissement, et
dans lequel l'ensemble électronique de puissance comprend en outre une couche de matériau à base de carbone (50) agencée entre la plaque de base du module électronique de puissance et la surface de refroidissement de l'agencement de refroidissement, la couche de matériau à base de carbone (50) étant conçue pour répandre la chaleur (61) générée par les composants de commutation électroniques de puissance à semi-conducteurs et pour transférer la chaleur de l'ensemble électronique de puissance à l'agencement de refroidissement, dans lequel la couche de matériau à base de carbone est une couche distincte de graphite naturel, graphite pyrolytique ou graphite synthétique, dans lequel l'épaisseur de la couche de matériau à base de carbone est dans la plage allant de 75 µm à 250 µm et dans lequel la dureté de la couche de matériau à base de carbone est inférieure à 10 à Shore 00.

2. Ensemble électronique de puissance selon la revendication 1, dans lequel au moins un des un ou plusieurs caloducs est agencé à la surface de la surface de refroidissement de l'élément de refroidissement.

3. Ensemble électronique de puissance selon l'une quelconque des revendications précédentes 1 à 2, dans lequel au moins un des un ou plusieurs caloducs est agencé en dessous d'au moins un composant de commutation électronique du module électronique de puissance lorsque vu depuis la direction du module électronique de puissance.

4. Ensemble électronique de puissance selon l'une quelconque des revendications précédentes 1 à 3, dans lequel au moins un des un ou plusieurs caloducs est agencé en dessous de deux composants de commutation électroniques du module électronique de puissance lorsque vu depuis la direction du module électronique de puissance, et de préférence les deux composants de commutation électroniques ont des pertes de puissance différentes.

5. Ensemble électronique de puissance selon l'une quelconque des revendications précédentes 1 à 4, dans lequel l'ensemble comprend au moins deux caloducs et dans lequel les caloducs sont agencés à des niveaux différents et/ou à des orientations différentes dans l'agencement de refroidissement.

6. Ensemble électronique de puissance selon l'une quelconque des revendications précédentes 1 à 5, dans lequel au moins l'un des un ou plusieurs caloducs est agencé à un angle déviant de zéro par rapport à la surface de refroidissement de l'agencement de refroidissement.

7. Ensemble électronique de puissance selon l'une quelconque des revendications précédentes 1 à 6, dans lequel au moins l'un des multiples composants électroniques de puissance à semi-conducteurs du module électronique de puissance est évalué à un courant dans la plage de centaines d'ampères.

8. Ensemble électronique de puissance selon l'une quelconque des revendications précédentes 1 à 7, dans lequel la longueur de la plaque de base du module électronique de puissance est dans la plage de plus de 100 millimètres.

9. Dispositif électronique de puissance comprenant un ou plusieurs ensembles électroniques de puissance selon l'une quelconque des revendications précédentes 1 à 8.

10. Dispositif électronique de puissance selon la revendication 9, le dispositif électronique de puissance étant un convertisseur de fréquence.

11. Procédé de fabrication d'un ensemble électronique de puissance comprenant les étapes consistant à fournir un module électronique de puissance intégrant de multiples composants de commutation électroniques à semi-conducteurs, le module électronique de puissance comprenant une plaque de base,
fournir un agencement de refroidissement pour refroidir le module électronique de puissance, l'agencement de refroidissement comprenant une surface de refroidissement conçue pour être fixée contre la plaque de base du module électronique de puissance et un ou plusieurs caloducs pour répandre la chaleur dans l'agencement de refroidissement et évacuer la chaleur de l'agencement de refroidissement,
fournir une couche à base de carbone, la couche de matériau à base de carbone étant une couche distincte de graphite naturel, de graphite pyrolytique ou de graphite synthétique entre la plaque de base du module électronique de puissance et la surface de refroidissement de l'agencement de refroidissement, la couche de matériau à base de carbone étant conçue pour répandre la chaleur générée par les composants de commutation électroniques de puissance à semi-conducteurs et pour transférer la chaleur de l'ensemble électronique de puissance à l'agencement de refroidissement, dans lequel l'épaisseur de la couche de matériau à base de carbone est dans la plage allant de 75 µm à 250 µm et dans lequel la dureté de la couche de matériau à base de carbone est inférieure à 10 à Shore 00, et
assujettir le module électronique de puissance à l'agencement de refroidissement à l'aide de moyens d'assujettissement.
